# EUROPEAN PATENT APPLICATION

(11) **EP 2 066 161 A1**
(43) Date of publication of application: **03.06.2009**
(21) Application number: 08752581.2
(22) Date of filing: 12.05.2008
(51) Int. Cl.: H05K 3/46

(54) **METHOD FOR MANUFACTURING SUBSTRATE WITH BUILT-IN COMPONENT AND SUBSTRATE WITH BUILT-IN COMPONENT**

(30) Priority: 19.06.2007 JP 2007161513
(71) Applicant: Murata Manufacturing Co. Ltd., Nagaokakyo-shi, Kyoto 617-8555 (JP)
(72) Inventor: YAMAKOSHI, Yusuke, Nagaokakyo-shi Kyoto-fu 617-8555 (JP)
(74) Representative: Schoppe, Fritz
(86) International application number: PCT/JP2008/058698
(87) International publication number: WO 2008/155957

(57) **Abstract**

To provide a method for manufacturing a component-embedded substrate that can form an interlayer connection conductor having a small diameter and high straightness and thus can achieve a miniaturized component-embedded substrate including interlayer connection conductors at a narrow pitch, and the component-embedded substrate. In a component-embedded substrate 40, a component 9 is embedded in an uncured resin layer 11 of a second layer 11.

After curing the resin layer 11, a hole 12 passing through the second layer 11 in the vertical direction is formed. The hole 12 is filled with an electroconductive paste to form a second interlayer connection conductor 8. A first in-plane conductor 2 including a plurality of lands 2a, a first layer 6, and the second layer 11 are stacked in that order and pressed to join together, and the first layer 6 is heated to form an integrated structure.

## Description

### Technical Field

The present invention relate to a method for manufacturing a component-embedded substrate made of a resin in which a component is embedded, and to the component-embedded substrate.

### Background Art

As electronic apparatuses are being miniaturized and sophisticated, various component-embedded substrates have been proposed which closely contains electronic components, such as capacitors, chip resistors, chip coils, and IC's, with high functionality.

Such a component-embedded substrate includes a component-embedded layer that is prepared by mounting components on, for example, a multilayer substrate (multilayer printed circuit board), a wired transfer plate, and embedding the components in a resin. In the component-embedded layer, a hole through which in-plane conductors disposed on the upper and lower surfaces will be electrically connected is formed by a laser or the like. In order to give electroconductivity to the hole, the inter wall of the hole is plated or the hole is filled with an electroconductive paste. Thus, an interlayer connection conductor is formed and the upper and lower in-plane conductors are electrically connected to each other.

The hole in which the interlayer connection conductor is formed may be called a "through-hole" or a "blind hole", depending on how the hole is formed.

The through-hole is formed by irradiating the component-embedded layer with laser light from above with no in-plane conductor disposed on the upper or the lower surface of the component-embedded layer (see, for example, Patent Document 1). In Patent Document 1, the through-hole is filled with an electroconductive paste and then the resin embedding the components is cured with the in-plane conductors disposed on the upper and lower surfaces. Thus, the component-embedded layer having the through-hole and the in-plane conductors are integrated with each other.

The blind hole is formed by irradiating the component-embedded layer with laser light from above with the in-plane conductor disposed on the lower surface. For example, components and an in-plane conductor are disposed in an uncured resin, followed by curing the resin to integrate. Then, a blind hole is formed in the component-embedded layer and filled with an electroconductive paste.

Patent Document 1: Japanese Unexamined Patent Application Publication No. 11-220262 (paragraphs [0056]-[0064], Fig. 2, etc.)

### Disclosure of Invention

### Problems to be Solved by the Invention

When a through-hole is formed as described in Patent Document 1, the through-hole is formed in an uncured resin, then the in-plane conductors and the component-embedded layer are integrated, and the resin is cured. Since the resin is shrunk when being cured, however, the straightness of the through-hole is reduced to cause displacement from the land of the in-plane conductor.

The blind hole is formed with a land of the in-plane conductor used as the bottom. When laser light is irradiated to form a blind hole, the laser light is reflected from the land and the reflected laser light cuts the resin to form the blind hole. Consequently, the diameter of the hole becomes large. Also, in order to prevent damage to the land, only weak laser light can be irradiated. This makes the shape of the hole tapered (having a trapezoidal section). When the hole in this state is plated from the upper surface of the component-embedded layer, the plating layer needs to extend to and cover the bottom of the blind hole, or when an electroconductive paste is injected from the upper surface of the component-embedded layer, the paste needs to reach the bottom of the blind hole. In order to cover the bottom of the blind hole as above, the diameter of the hole (diameter of the upper open end of the hole) must be increased. Consequently, the lands for blind holes cannot be arranged at a narrow pitch, and thus the miniaturization of the component-embedded substrate is hampered.

An object of the present invention is to provide a method for manufacturing a component-embedded substrate that can form a highly straight interlayer connection conductor having a small diameter and thus can achieve a miniaturized substrate with high reliability, and is to provide such a component-embedded substrate.

### Means for Solving the Problems

Accordingly, a method for manufacturing a component-embedded substrate of the present invention includes: the step of forming a first in-plane conductor including a plurality of lands; the step of forming a first interlayer connection conductor in a first layer made of an uncured resin at a position corresponding to a specific one of the lands; the step of embedding a component in a second layer made of an uncured resin and subsequently curing the second layer; the step of forming a second interlayer connection conductor passing through the cured second layer from the upper surface to the lower surface at a position corresponding to the first interlayer connection conductor; and the step of stacking the first in-plane conductor, the first layer, and the second layer in that order and subsequently curing the first layer, thereby integrating the first in-plane conductor, the first layer, and the second layer. Thus, the first in-plane conductor, the first interlayer connection conductor, and the second interlayer connection conductor are electrically connected from one to another (Claim 1).

A method for manufacturing a component-embedded substrate of the present invention includes the step of forming a first interlayer connection conductor in a first layer made of an uncured resin having a first in-plane conductor including a plurality of lands. The first interlayer connection conductor has a bottom defined by a specific one of the lands. The method also includes the step of embedding a component in a second layer made of an uncured resin and subsequently curing the second layer; the step of forming a second interlayer connection conductor passing through the second layer from the upper surface to the lower surface at a position corresponding to the first interlayer connection conductor; and the step of stacking the first layer and the second layer in that order and subsequently curing the first layer, thereby integrating the first layer and the second layer. Thus, the first in-plane conductor, the first interlayer connection conductor, and the second interlayer connection conductor are electrically connected from one to another (Claim 2).

The method for manufacturing a component-embedded substrate according to Claim 1 or 2 may further include the step of forming a second in-plane conductor electrically connected to the second interlayer connection conductor on the upper surface of the second layer (Claim 3).

The method for manufacturing a component-embedded substrate according to Claim 1 or 2, may further include the step of preparing an uncured third layer having a second in-plane conductor on one surface thereof and disposing the third layer on the second layer, thereby electrically connecting the second in-plane conductor to the second interlayer connection conductor (Claim 4).

The method for manufacturing a component-embedded substrate according to any one of Claims 1 to 4 may further include the step of exposing the component after the step of embedding the component in the uncured second layer and curing the second layer (Claim 5).

In the method for manufacturing a component-embedded substrate according to any one of Claims 1 to 5, the component may be embedded in the uncured second layer after the component is mounted on an electrode formed on a transfer plate, and the transfer plate is removed from the second layer after the second layer is cured (Claim 6).

In the method for manufacturing a component-embedded substrate according to any one of Claims 1 to 6, the first layer and the second layer may be formed of the same material (Claim 7).

A component-embedded substrate of the present invention includes: a first in-plane conductor including a plurality of lands; a first layer disposed on the first in-plane conductor; a first interlayer connection conductor formed in the first layer and electrically connected to a specific one of the lands; a second layer made of a resin embedding a component, disposed on the first layer; a second interlayer connection conductor formed in the second layer and electrically connected to the first interlayer connection conductor; and a second in-plane conductor disposed on the upper surface of the second layer and electrically connected to the second interlayer connection conductor (Claim 8).

A component-embedded substrate of the present invention includes: a first in-plane conductor including a plurality of lands; a resin first layer disposed on the first in-plane conductor; an interlayer connection conductor formed in the first layer and electrically connected to a specific one of the lands; a second layer made of a resin embedding a component, disposed on the first layer; a second interlayer connection conductor formed in the second layer and electrically connected to the first interlayer connection conductor; a resin third layer disposed on the second layer; a third interlayer connection conductor formed in the third layer and electrically connected to the second interlayer connection conductor; and a second in-plane conductor disposed in the upper surface of the third layer and electrically connected to the third interlayer connection conductor (Claim 9).

### Advantages of the Invention

Since the second layer in the present invention embeds a component, the second layer is higher than the other layers. In the method of the present invention, the second layer is cured after embedding the component, and then a second interlayer connection conductor is formed in a through-hole. Consequently, the straightness of the second interlayer connection conductor can be prevented from being degraded, and the reliability of the entire component-embedded substrate can be enhanced. Also, since the second interlayer connection conductor is formed in the through-hole, but not a blind hole, the second interlayer connection conductor can have a small diameter. Accordingly, the component-embedded substrate can be miniaturized. In particular, the invention according to Claim 5 reduces the thickness of the second layer up to the height of the component, thereby forming a highly straight through-hole.

### Brief Description of Drawings

Fig. 1 is a sectional view of a component-embedded substrate according to a first embodiment of the invention.
Fig. 2 is a representation of the step of forming a first in-plane conductor of the component-embedded substrate shown in Fig. 1.
Fig. 3 is a representation of the step of forming a first layer of the component-embedded substrate shown in Fig. 1.
Fig. 4 is a representation of the step of forming a second layer of the component-embedded substrate shown in Fig. 1.
Fig. 5 is a sectional view of the first in-plane conductor, the first layer, and the second layer of the component-embedded substrate shown in Fig. 1 before they are integrated.
Fig. 6 is a sectional view of a component-embedded substrate according to a second embodiment.
Fig. 7 is a representation of the step of forming a third layer of the component-embedded substrate shown in Fig. 6.
Fig. 8 is a sectional view of the first in-plane conductor, the first layer, the second layer, and the third layer of the component-embedded substrate shown in Fig, 6 before they are integrated.
Fig. 9 is a sectional view of a component-embedded substrate according to a third embodiment.
Fig. 10 is a representation of the step of forming the first layer of the component-embedded substrate shown in Fig. 9.
Fig. 11 is a sectional view of the first layer, the second layer, and the third layer of the component-embedded substrate shown in Fig. 9 before they are integrated.
Fig. 12 is a sectional view of a modification of the component-embedded substrate according to the third embodiment.
Fig. 13 is a sectional view of the first layer, the second layer, and the third layer of the component-embedded substrate shown in Fig. 12 before they are integrated.
Fig. 14 is a sectional view of the component-embedded substrate shown in Fig. 12 after removing a transfer plate.
Fig. 15 is a sectional view of a component-embedded substrate according to a fourth embodiment.
Fig. 16 is a representation of the step of forming the second layer of the component-embedded substrate shown in Fig. 15.
Fig. 17 is a sectional view of the first layer, the second layer, and the third layer of the component-embedded substrate shown in Fig. 15 before they are integrated.
Fig. 18 is a sectional view of the component-embedded substrate shown in Fig. 15 after removing a transfer plate.
Fig. 19 is a sectional view of a component-embedded substrate according to a fifth embodiment.
Fig. 20 is a representation of the step of forming the second layer of the component-embedded substrate shown in Fig. 19.
Fig. 21 is a representation of the step of forming the second layer of the component-embedded substrate shown in Fig. 19.
Fig. 22 is a sectional view of the first layer, the second layer, and the third layer of the component-embedded substrate shown in Fig. 19 before they are integrated.
Fig. 23 is a sectional view of the component-embedded substrate Shown Fig. 19 after removing a transfer plate.

### Reference Numerals

- 2: first in-plane conductor
- 2a: land
- 5, 22: first interlayer connection conductor
- 6: first layer
- 8, 34, 35: second interlayer connection conductor
- 9: component
- 11, 31, 41: second layer
- 16, 32: third layer
- 17, 26, 36: second in-plane conductor
- 19, 28, 39: third interlayer connection conductor
- 26a, 36a: land
- 42: electrode
- 40, 50, 60, 70, 80, 90: component-embedded substrate

### Best Modes for Carrying Out the Invention

### (First Embodiment)

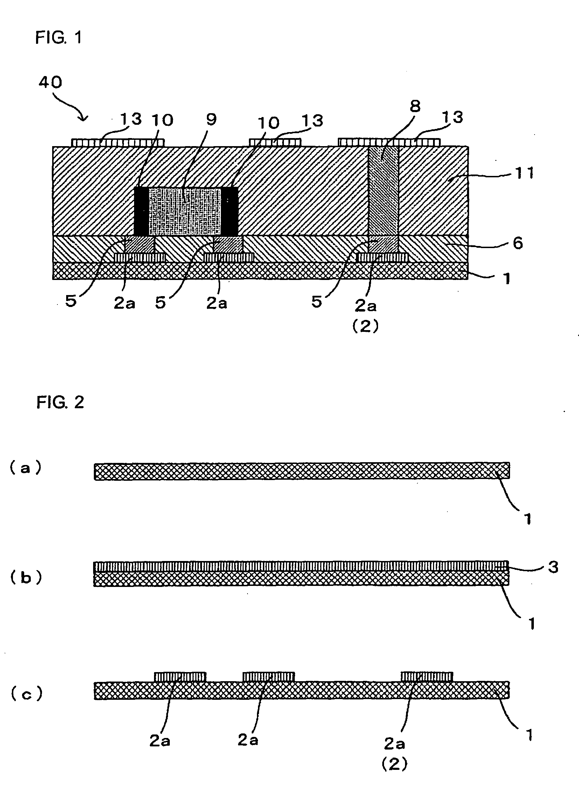

A first embodiment according to Claims 1, 3, and 8 will now be described with reference to Figs. 1 to 5. Fig. 1 is a sectional view of a component-embedded substrate, and Figs. 2 to 5 are representations of a method for manufacturing the component-embedded substrate.

The component-embedded substrate 40 shown in Fig. 1 includes a first in-plane conductor 2 including a plurality of lands 2a on the upper surface of a base plate 1. A first layer 6 made of a resin is disposed on the upper surface of the first in-plane conductor 2. The first layer 6 is provided with a first interlayer connection conductor 5 in it so as to be electrically connected to a specific land 2a of the plurality of lands 2a on the upper surface of the base plate 1. A second layer 11 made of a resin is further formed on the upper surface of the first layer 6, and in which a component 9 is embedded. Also, a second interlayer connection conductor 8 is formed and electrically connected to the first interlayer connection conductor 5. A second in-plane conductor 13 is formed on the upper surface of the second layer 11 and electrically connected to the second interlayer connection conductor 8. In the first layer 6, other first interlayer connection conductors 5 are formed at the positions corresponding to the electrodes 10 of the component 9. These first interlayer connection conductors 5 are electrically connected to other specific lands 2a of the first in-plane conductor 2. In other words, the first in-plane conductor 2 and the second in-plane conductor 13 are connected through a specific first interlayer connection conductor 5 and the second interlayer connection conductor 8, and the first in-plane conductor 2 and the electrodes 10 of the component 9 are connected through other specific first interlayer connection conductors 5.

The first in-plane conductor 2 may be formed on the surface of a base plate 1 made of a resin, a glass epoxy, a multilayer rein plate, or the like, or may be formed using a transfer plate made of, for example, SUS.

The first layer 6 and the second layer 11 are preferably formed of a thermosetting resin, such as an epoxy resin, from the viewpoint of ease of curing. Also, a photo-curable resin that can be cured by UV light may be used. It is desirable that a material difficult to shrink with heat be selected. Preferably, the first layer 6 and the second layer 11 are formed of the same material, so that the thermal expansion coefficient or other properties can be uniformized in the component-embedded substrate and, thus, the reliability can be enhanced.

The first interlayer connection conductors 5 and the second interlayer connection conductor 8 are each filled with an electroconductive paste. Thus, the first in-plane conductor 2 and the second in-plane conductor 13 disposed in the lower surface or on the upper surface of the component-embedded substrate 40 are electrically connected to each other, and the first in-plane conductor 2 and the electrodes 10 of the component 9 embedded in the second layer 11 are electrically connected to each other.

Then, a method for manufacturing the component-embedded substrate 40 will now be described.

Fig. 2 is a representation of the step of forming the first in-plane conductor 2. First, a copper foil layer 3 is formed on the upper surface of a base plate 1 shown in Fig. 2(a), as shown in Fig. 2(b). Then, the copper foil layer 3 is patterned into a first in-plane conductor 2 including a plurality of lands 2a by, for example, etching, as shown in Fig. 2(c). Alternatively, the first in-plane conductor 2 may be formed by plating the entire upper surface of the base plate 1 to form an electroconductive layer of an electroconductive metal, such as copper or a copper alloy, and patterning the electroconductive layer.

If the first in-plane conductor 2 is formed using a transfer plate made of, for example, SUS, the first in-plane conductor 2 can be transferred to the first layer 6 by forming and pressing an uncured first layer 6 on the transfer plate and then removing the transfer plate.

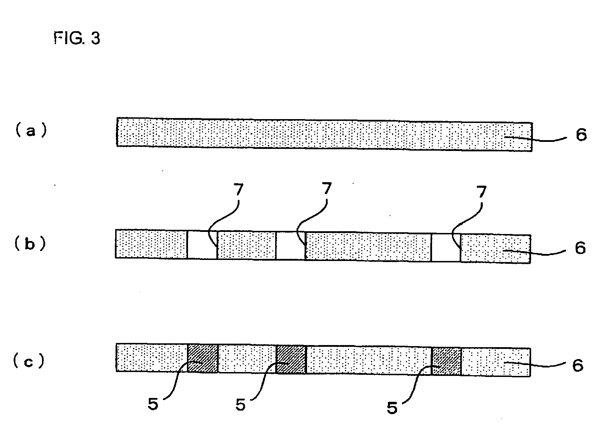

Fig. 3 is a representation of the step of forming the first layer 6. An uncured resin first layer 6 shown in Fig. 3(a) is irradiated with laser light from above, corresponding to the positions of the lands 2a of the first in-plane conductor 2. Thus, holes 7 are formed so as to pass through the first layer 6 in the vertical direction, as shown in Fig. 3(b). Then, as shown in Fig. 3(c), the holes 7 are filled with an electroconductive paste to form first interlayer connection conductors 5.

In this instance, the electroconductive paste is, for example, a resin paste containing an electroconductive material (metal).

Alternatively, the inner walls of the holes 7 shown in Fig. 3(b) may be plated to form the first interlayer connection conductors 5, instead of filling the holes 7 with the electroconductive paste. The first interlayer connection conductors 5 may be formed by plating the inner walls of the holes 7 and subsequently filling the holes 7 with an electroconductive paste or a non-electroconductive paste, or by injecting the electroconductive paste into the holes 7 up to a predetermined height and subsequently plating the inner walls of the holes 7.

The first layer 6 is formed thin without embedding a component or the like. Accordingly, the holes 7 are hardly deformed by the curing shrinkage of the resin even if the holes 7 are formed in the first layer 6 in an uncured state and then the first layer 6 is cured as described below.

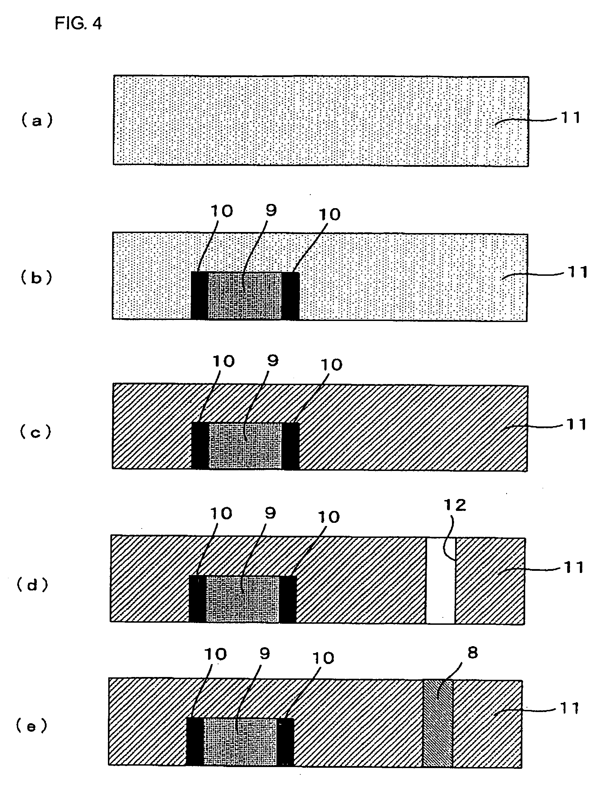

Fig. 4 is a representation of the step of forming the second layer 11. First, a second layer 11 made of an uncured resin is prepared, as shown in Fig. 4(a), and a component 9, such as a chip capacitor, a chip resistor, a chip coil, or IC, is embedded in the second layer 11, as shown in Fig. 4(b). In the figure, reference numeral 10 designates the electrodes of the component 9. Then, the second layer 11 embedding the component 9 is cured, as shown in Fig. 4(c), and the first layer 6 is irradiated with laser light corresponding to the position of a specific first interlayer connection conductor 5 to form a hole 12 passing through the second layer 11 in the vertical direction, as shown in Fig. 4(d). Subsequently, as shown in Fig. 4(e), the hole 12 is filled with an electroconductive paste to form a second interlayer connection conductor 8.

Instead of filling the hole 12 with the electroconductive paste, the inner wall of the hole 12 shown in Fig. 4(d) may be plated to form the second interlayer connection conductor 8. The second interlayer connection conductor 8 may be formed by filling the plated hole 12 with an electroconductive paste or a non-electroconductive paste, or by injecting the electroconductive paste into the hole 12 up to a predetermined height and subsequently plating the inner wall of the hole 12.

Although the second layer 11 is preferably formed of the same thermosetting epoxy resin as the first layer 6, other thermosetting or photo-curable resins may of course be used. As with the first layer 6, a material difficult to shrink is desirably used.

Since the component 9 is embedded in the second layer 11, the second layer 11 has a certain height. Since the hole 12 is formed with the second layer 11 cured, the hole 12 is not deformed after the formation. Also, since the hole 12 is formed as a through-hole without disposing an in-plane conductor on the upper surface or the lower surface of the second layer 11, the second interlayer connection conductor 8 is not tapered, but is straight.

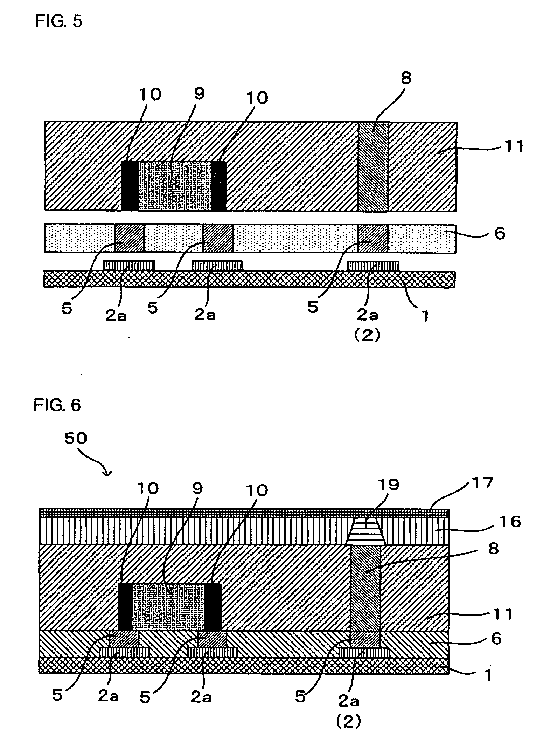

Turning now to Fig. 5, the first in-plane conductor 2 including the plurality of lands 2a, the first layer 6, and the second layer 11 are integrated. In this instance, the first in-plane conductor 2 of the base plate 1, the first layer 6, and the second layer 11 are stacked in that order and pressed to join together. In this state, the first layer 6 is cured to electrically connect a specific land 2a of the first in-plane conductor 2, the corresponding first interlayer connection conductor 5, and the second interlayer connection conductor 8 to one another, and other specific lands 2a, the corresponding first interlayer connection conductors 5, and the electrodes 10 of the component 9 to one another.

Finally, the upper surface of the integrated component-embedded substrate 40 is plated with an electroconductive metal, such as copper or a copper alloy, to form an electroconductive layer. The electroconductive layer is patterned by etching or the like to form a second in-plane conductor 13. Thus, the component-embedded substrate 40 as shown in Fig. 1 is completed. The second in-plane conductor 13 may not be patterned. If, for example, the resulting component-embedded substrate 40 is formed on the uppermost layer of a multilayer substrate, the second in-plane conductor 13 is formed over the entire upper surface of the second layer 11 so as to act as a shield electrode.

In the first embodiment, as described above, the hole 12 is a through-hole formed without disposing an in-plane conductor on the upper surface or the lower surface. The diameter of the hole 12 intended for the second interlayer connection conductor 8 is therefore not increased, and accordingly narrow pitch wiring can be made. Also, since the second interlayer connection conductor 8 is formed after curing the second layer 11, the straightness of the second interlayer connection conductor 8 is not degraded by the curing shrinkage of the second layer 11. Consequently, reliable wiring can be made. As described above, the first interlayer connection conductors 5 are formed with the first layer 6 uncured. However, the straightness of the first interlayer connection conductors 5 is hardly affected by the curing shrinkage of the first layer 6 because of the small thickness of the first layer. Therefore, the pitch can be reduced in the entire component-embedded substrate 40 and the reliability can be increased, by forming the hole 12 intended for the second interlayer connection conductor 8 with a small diameter, and by maintaining the straightness of the hole 12.

### (Second Embodiment)

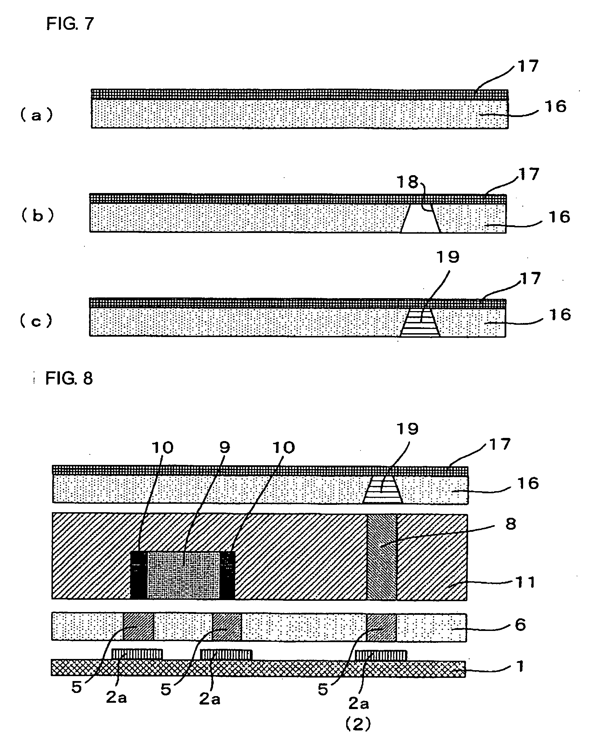

A second embodiment according to Claims 1, 4, and 9 will be described with reference to Figs. 6 to 8. Fig. 6 is a sectional view of a component-embedded substrate 50, and Figs. 7 and 8 are representations of a method for manufacturing the component-embedded substrate 50. In Figs. 6 to 8, the same reference numerals as in Figs. 1 to 5 designate the same or equivalent parts.

As with the component-embedded substrate 40 of the first embodiment, the component-embedded substrate 50 of the present embodiment includes a first in-plane conductor 2, a first layer 6, and a second layer 11. While the first in-plane conductor 2, the first layer 6, and the second layer 11 have the same structure as in the first embodiment, the present embodiment is different from the first embodiment in that a third layer 16 having a second in-plane conductor 17 is provided on the second layer 11, as shown in Fig. 6.

Fig. 7 is a representation of the step of forming the third layer 16 on which the second in-plane conductor 17 is disposed. As shown in Fig. 7(a), the second in-plane conductor 17 is formed of, for example, copper foil on the upper surface of the third layer 16 made of an uncured resin. Since the third layer 16 is uncured, the copper foil second in-plane conductor 17 can be easily formed by pressing the copper foil to join. Then, the third layer 16 is irradiated with laser light from below corresponding to the position of the second interlayer connection conductor 8 in the second layer 11. Thus a hole 18 is formed with the second in-plane conductor 17 used as the bottom, as shown in Fig. 7(b). Then, the hole 18 is filled with an electroconductive paste to form a third interlayer connection conductor 19, as shown in Fig. 7(C).

Instead of filling the hole 18 with the electroconductive paste, the inner wall of the hole 18 shown in Fig. 7(b) may be plated to form the third interlayer connection conductor 19. The third interlayer connection conductor 19 may be formed by plating the inner wall of the hole 18 and subsequently filling the plated hole 18 with an electroconductive paste, or by injecting the electroconductive paste into the hole 18 up to a predetermined height and subsequently plating the hole 18.

Although the third layer 16 is preferably formed of a thermosetting epoxy resin as the first layer 6 and the second layer 11 in the first embodiment, other thermosetting or photo-curable resins may be used. A material difficult to shrink is desirable. Preferably, the first layer 6, the second layer 11, and the third layer 16 are formed of the same material, so that the thermal expansion coefficient and other properties can be uniformized in the component-embedded substrate and, thus, the reliability can be enhanced.

The third layer 16 is formed thin without embedding a component. Accordingly, the hole 18 is hardly deformed by the shrinkage of the third layer 16 even if the hole 18 is formed in an uncured third layer 16 and then the third layer 16 is cured. The hole 18 intended for the third interlayer connection conductor 19 is a blind hole with the second in-plane conductor 17 used as the bottom, and the third interlayer connection conductor 19 is tapered as shown in Fig. 7. Since the hole has a small thickness, however, the hole 18 is not necessarily formed to a large diameter so as to be closely filled with an electroconductive paste. Thus, the shape and diameter of the hole 18 intended for the third interlayer connection conductor 19 hardly affect the reliability and the reduction in pitch of the entire component-embedded substrate.

Turning now to Fig. 8, the first in-plane conductor 2, the first layer 6, the second layer 11, and the third layer 16 are stacked in that order and pressed to join together. In this state, the first layer 6 and the third layer 16 are cured by heating or other means to electrically connect a specific land 2a of the first in-plane conductor 2, the corresponding first interlayer connection conductor 5, the second interlayer connection conductor 8, and the third interlayer connection conductor 19 to one another, and other specific lands 2a, the corresponding first interlayer connection conductors 5, and the electrodes 10 of the component 9 to one another. Thus, the component-embedded substrate 50 shown in Fig. 6 is assembled.

The copper foil layer formed on the upper surface of the integrated component-embedded substrate 50 may be patterned into the second in-plane conductor 17 by, for example, etching. Alternatively, an electroconductive layer may be formed of an electroconductive metal, such as copper or a copper alloy, by plating or other means. A transfer plate made of, for example, SUS may be used for forming the second in-plane conductor 17.

In the second embodiment as well as the first embodiment, as described above, the second interlayer connection conductor 8 is formed with the second layer 11 cured. Consequently, the straightness of the second interlayer connection conductor 8 is not degraded. Since the hole 12 intended for the second interlayer connection conductor 8 is a through-hole, the diameter of the hole 12 is not increased. By straightly forming the second interlayer connection conductor 8 with a small diameter in the highest second layer 11, the pitch can be reduced in the entire component-embedded substrate 50 and the reliability can be enhanced.

In the second embodiment, the third layer 16 having the second in-plane conductor 17 is provided. Consequently, the step of plating the upper surface of the second layer 11 to form an electroconductive layer is not required after integrating the first in-plane conductor 2, the first layer 6, and the second layer 11, unlike the first embodiment. In addition, the third interlayer connection conductor 19 is formed with the second in-plane conductor 17 used as the bottom. Thus, the reliability in continuity can be enhanced between the second in-plane conductor 17 and the third interlayer connection conductor 19.

### (Third Embodiment)

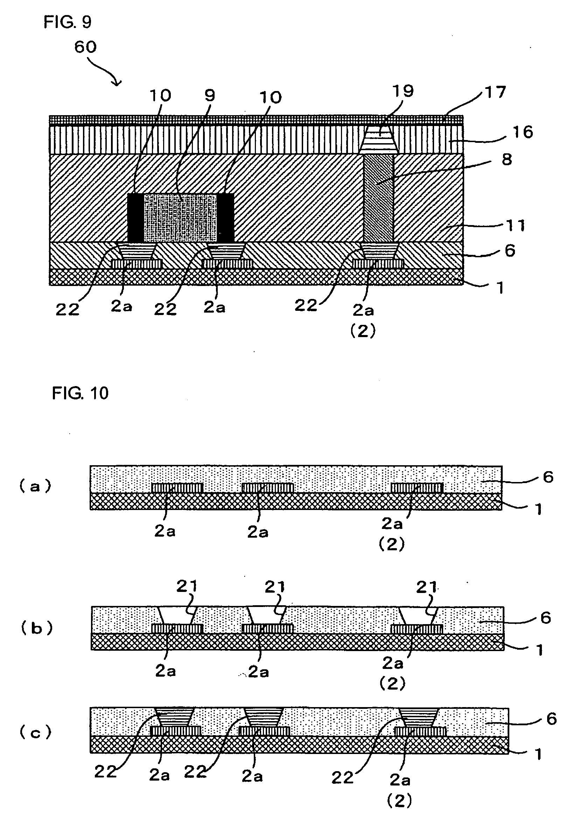

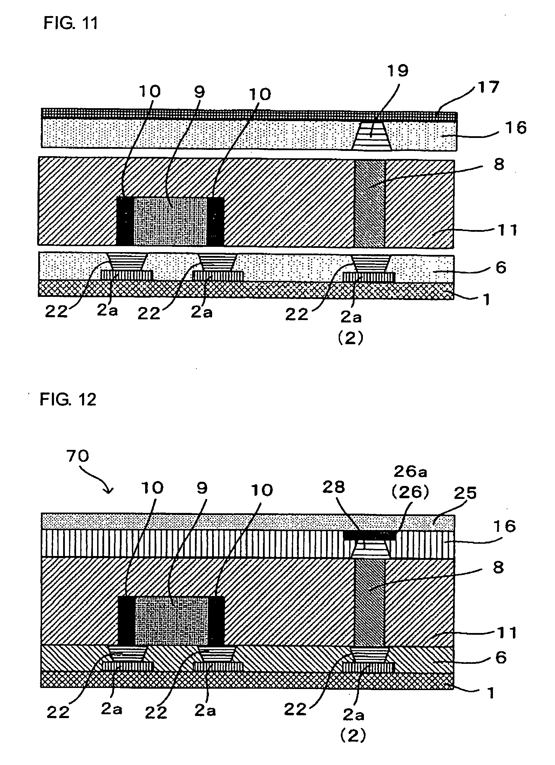

A third embodiment according to Claims 2 and 4 will be described with reference to Figs. 9 to 11. Fig. 9 is a sectional view of a component-embedded substrate 60, and Figs. 10 and 11 are representations of a method for manufacturing the component-embedded substrate 60. In Figs. 9 to 11, the same reference numerals as in Figs. 1 to 8 designate the same or equivalent parts.

The component-embedded substrate 60 of the present embodiment is different from the component-embedded substrate 50 of the second embodiment in that the first layer 6 is stacked and pressed on the first in-plane conductor 2 to join together and subsequently first interlayer connection conductors 22 are formed with the first layer uncured, as shown in Fig. 9. The second layer 11, the third 16, and the second in-plane conductor 17 are formed in the same manner as in the second embodiment.

Fig. 10 is a representation of the step of forming the first layer 6 of the present embodiment. As shown in Fig. 10(a), a first in-plane conductor 2 including a plurality of lands 2a is formed on the upper surface of a base plate 1 in the same manner as the first in-plane conductor 2 of the first embodiment, and then an uncured resin first layer 6 is formed on the first in-plane conductor 2. Then, the first in-plane conductor 2 is irradiated with laser light corresponding to the positions of the lands 2a to form holes 21 with the lands 2a used as the bottoms, as shown in Fig. 10(b). Then, the holes 21 are filled with an electroconductive paste to form first interlayer connection conductors 22, as shown in Fig. 10(c). Although the holes 21 of the first interlayer connection conductors 22 are tapered (with a trapezoidal section), there is no problem because of the small thickness of the first layer 6. The holes 21 may be plated instead of filling the holes 21 with an electroconductive paste.

Turning now to Fig. 11, the first layer 6 including the first in-plane conductor 2, the second layer 11, and the third layer 16 including the second in-plane conductor 17 are integrated. In this state, the first layer 6 and the third layer 16 are cured by heating or other means to electrically connect a specific lands 2a of the first in-plane conductor 2, the corresponding first interlayer connection conductor 22, the second interlayer connection conductor 8, and the third interlayer connection conductor 19, and the second in-plane conductor 17 to one another, and other specific lands 2a, the corresponding first interlayer connection conductors 22, and the electrodes 10 of the component 9 are electrically connected to one another. Thus, the component-embedded substrate 60 shown in Fig. 9 is assembled.

In the third embodiment as well, as described above, the second interlayer connection conductor 8 is formed with the second layer 11 cured. Consequently, the straightness of the second interlayer connection conductor 8 is not degraded. Since the hole 12 intended for the second interlayer connection conductor 8 is a through-hole, the diameter of the holes 12 is not increased. By straightly forming the second interlayer connection conductor 8 with a small diameter in the highest second layer 11, the pitch can be reduced in the entire component-embedded substrate 60 and the reliability can be enhanced.

In the second embodiment, the first interlayer connection conductors 22 are formed with the first in-plane conductor 2 used as the bottoms. Consequently, the reliability in continuity can be enhanced between the first in-plane conductor 2 and the first interlayer connection conductors 22.

If the first in-plane conductor 2 is formed using a transfer plate made of, for example, SUS, an uncured first layer 6 is formed and pressed on the transfer plate to join together, and the transfer plate is removed after curing the first layer 6 through predetermined steps. Thus, the first in-plane conductor 2 can be transferred to the first layer 6.

### (Modification)

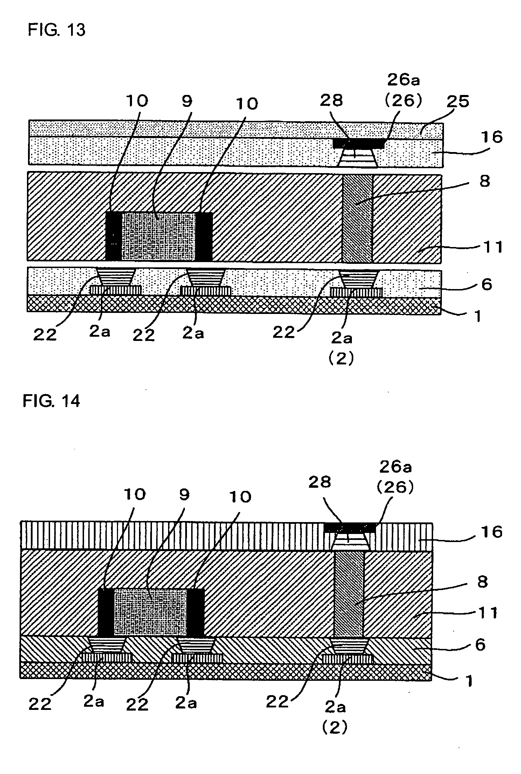

A modification of the third embodiment according to Clams 2 and 4 will be described with reference to Figs. 12 to 14. Fig. 12 is a sectional view of a component-embedded substrate 70, and Figs. 13 and 14 are representations of a method for manufacturing the component-embedded substrate 70. In Figs. 12 to 14, the same reference numerals as in Figs. 1 to 11 designate the same or equivalent parts.

In the component-embedded substrate 70 of the modification, the second in-plane conductor 17 of the component-embedded substrate 60 according to the third embodiment is replaced with a second in-plane conductor 26 formed on a transfer plate 25, as shown in Fig. 12. The transfer plate 25 including the second in-plane conductor 26 is stacked and pressed on an uncured resin third layer 16 to join together. The second in-plane conductor 26 is embedded in the third layer 16 at this point. In this state, the third layer is irradiated with laser light corresponding to the positions of a plurality of lands of the second in-plane conductor 26. Thus, a hole (not shown) is formed with the second in-plane conductor 26 used as the bottom. The hole is filled with an electroconductive paste to form a third interlayer connection conductor 28.

Turning now to Fig. 13, the first layer 6 including the first in-plane conductor 2, the second layer 11, and the third layer 16 including the second in-plane conductor 26 are stacked in that order and pressed to join together. In this state, the first layer 6 and the third layer 16 are cured by heading or other means to electrically connect a specific land 2a of the first in-plane conductor 2, the corresponding first interlayer connection conductor 22, the second interlayer connection conductor 8, the third interlayer connection conductor 28, and the corresponding land 26a of the second in-plane conductor 26 to one another, and other specific lands 2a, the corresponding first interlayer connection conductors 22, and the electrodes 10 of the component 9 to one another. Thus, the component-embedded substrate 70 shown in Fig. 12 is assembled. Then, the transfer plate 25 is removed from the upper surface of the third layer 16, as shown in Fig. 14.

In this modification, the first in-plane conductor 2 embedded in the first layer 6 may also be formed using a transfer plate, as well as the second in-plane conductor 26 embedded in the third layer 16.

If the second in-plane conductor 26 is formed using a transfer plate made of, for example, SUS, an uncured third layer 16 is formed and pressed on the transfer plate to join together, and the transfer plate 25 is removed after curing the third layer 16 by heating or other means. Thus, the second in-plane conductor 26 can be transferred into the third layer 16. This process does not require a step for forming the second in-plane conductor 17 by patterning after integration of the first layer 6, the second layer 11, and the third layer 16. The same can apply the first in-plane conductor 2.

Although the first layer 6, the second layer 11, and the third layer 16 are preferably formed of the same thermosetting epoxy resin, other thermosetting or photo-curable resins may be used. A material difficult to shrink is desirable. Preferably, the first layer 6, the second layer 11, and the third layer 16 are formed of the same material, so that the thermal expansion coefficient and other properties can be uniformized in the component-embedded substrate and, thus, the reliability can be enhanced.

### (Fourth Embodiment)

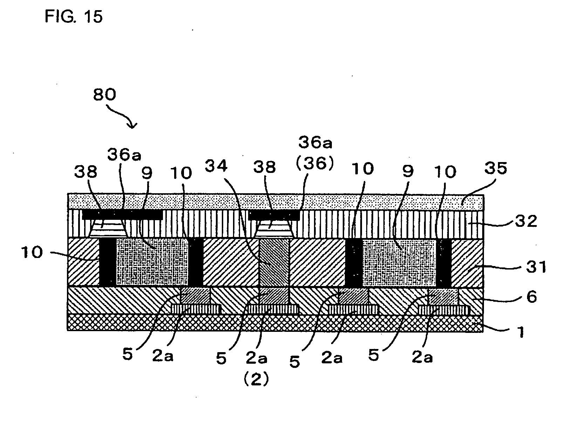

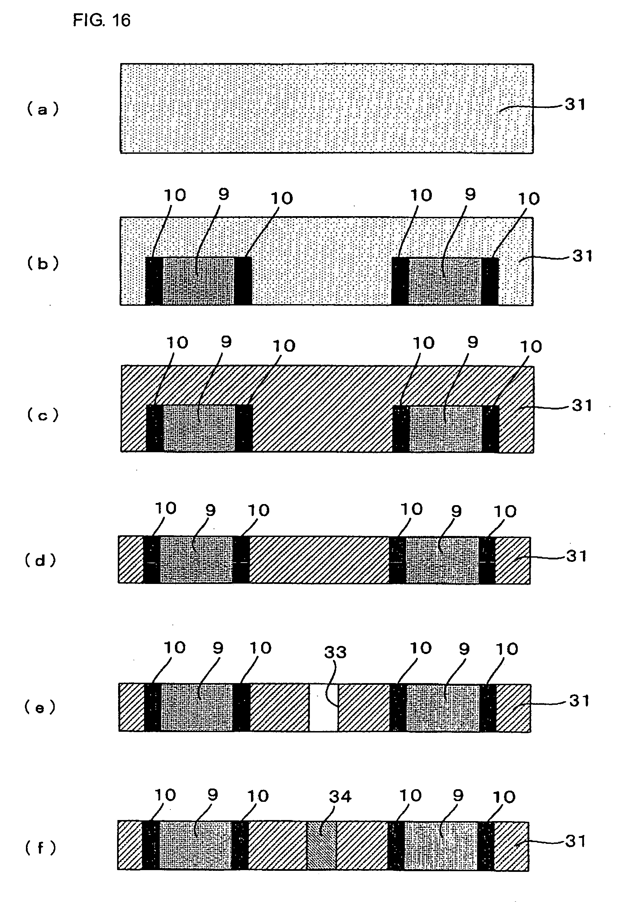

A fourth embodiment according to Clam 5 will be described with reference to Figs. 15 to 18. Fig. 15 is a sectional view of a component-embedded substrate 80, and Figs. 16 to 18 are representations of a method for manufacturing the component-embedded substrate 80. In Figs. 15 to 18, the same reference numerals as in Figs. 1 to 14 designate the same or equivalent parts.

The component-embedded substrate 80 of the present embodiment is substantially the same as in the first and second embodiments, but is different in that the upper surface of the second layer 31 embedding the component 9 is ground to expose the component 9 at the upper surface of the second layer 31, thus reducing the thickness of the second layer 31 before the second layer 31, the first layer 6, and the third layer 32 are integrated, as shown in Fig. 15. The first layer 6 is formed in the same manner as in the first and second embodiments.

Fig. 16 is a representation of the step of forming the second layer 31. First, an uncured resin second layer 31 is prepared, as shown in Fig. 16(a), and components 9, such as chip capacitors, chip resistors, chip coils, and IC's, are embedded, as shown in Fig. 16(b). In the figure, reference numeral 10 designates the electrodes of the component 9. Then, the second layer 31 embedding the component 9 is cured, as shown in Fig. 16(c), and the upper surface of the second layer 31 is mechanically ground to expose the components 9 at the upper surface of the second layer 31, and thus the thickness of the second layer 31 is reduced.

Turning now to Fig. 16(e), the second layer 31 is irradiated with laser light corresponding to the position of a specific first interlayer connection conductor 5 in the first layer 6 to form a hole 33 passing through the second layer 31 in the vertical direction. Subsequently, the hole 33 is filled with an electroconductive paste to form a second interlayer connection conductor 34, as shown in Fig. 16(f).

Since the hole 33 is formed with the second layer 31 cured, the hole 33 is not deformed after the formation. Since the hole 33 is a through-hole formed without disposing an in-plane conductor on the upper surface or the lower surfaces of the second layer 31, the second interlayer connection conductor 34 is not tapered, but is straight. In addition, the thickness of the second layer 31 is reduced to the extent that the component 9 is exposed at the upper surface of the second layer, and accordingly, the shape of the hole 33 can be straighter.

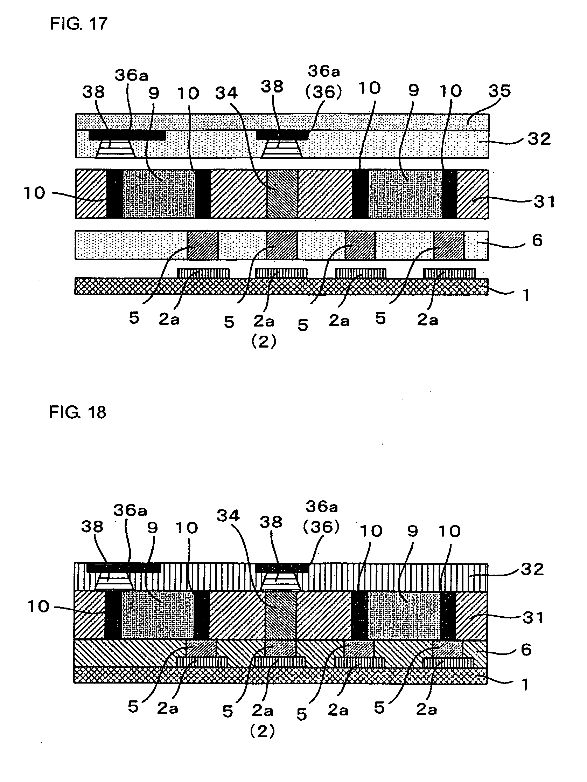

The third layer 32 is formed in the same manner as in the modification of the third embodiment. More specifically, as shown in Fig. 17, a transfer plate 35 including a second in-plane conductor 36 is disposed on the uncured resin third layer 32 and pressed to join together. The second in-plane conductor 36 is embedded in the third layer 32 at this point. In this state, the third layer 32 is irradiated with laser light from below corresponding to the positions of lands 36a of the second in-plane conductor 36. Thus, the holes (not shown) are formed with the second in-plane conductor 36 used as the bottoms. The holes are filled with an electroconductive paste to form third interlayer connection conductors 38.

Turning now to Fig. 17, the first in-plane conductor 2, the first layer 6, the second layer 31, and the third layer 32 including the second in-plane conductor 36 are stacked in the order to join together. In this state, the first layer 6 and the third layer 32 are cured by heating or other means to electrically connect a specific land 2a of the first in-plane conductor 2, the corresponding first interlayer connection conductor 5, the second interlayer connection conductor 34, the third interlayer connection conductor 38, and the corresponding land 36a of the second in-plane conductor 36 to one another, and other specific lands 2a, the corresponding first interlayer connection conductors 5, the electrodes 10 of the components, the corresponding third interlayer connection conductor 38, and the corresponding land 36a of the second in-plane conductor 36 to one another. Thus, the component-embedded substrate 80 is assembled. The transfer plate 35 is finally removed from the upper surface of the third layer 32, as shown in Fig. 18.

The first in-plane conductor 2 in the first layer 6 may also be formed using a transfer plate, as well as the second in-plane conductor 36 in the third layer 32.

In the fourth embodiment, the thickness of the second layer 31 is reduced before being integrated with the first layer 6 and the third layer 32. Accordingly, the second interlayer connection conductor 34 can be formed straighter, and the diameter of the hole 33 intended for the second interlayer connection conductor 34 can be reduced. Thus, the pitch can be reduced. If the electrodes 10 of the component 9 are exposed at the upper surface of the second layer 31, the electrodes 10 and the third interlayer connection conductor 38 in the third layer 32 can be electrically connected directly. Thus, wiring can be more arbitrarily performed and effective wiring becomes possible.

The step of reducing the thickness of the second layer 31 may be performed after forming the hole 33, or after filling the hole 33 with an electroconductive paste to form the second interlayer connection conductor 34, without limiting to the time before forming the hole 33, as long as this step is performed after curing the second layer 31 embedding the component 9 and before integrating the first layer 6, the second layer 31, and the third layer 32.

In the fourth embodiment, the second in-plane conductor 36 is formed using the transfer plate 35 made of, for example, SUS. This method does not require the step of patterning the second in-plane conductor 36 by etching or the like after the integration of the first layer 6, the second layer 31, and the third layer 32.

The formation of the third layer 32 is not limited to using the transfer plate 35 as in the present embodiment. For example, the second in-plane conductor may be formed by patterning a plated electroconductive layer, a copper foil, or the like, by etching or the like.

The reduction of the thickness of the second layer 31 is not limited to mechanical grinding of the upper surface of the second layer 31, and other techniques may be applied. For example, the second layer 31 may be cut to a predetermined height so that the component 9 can be exposed at the upper surface of the second layer 31. The electrodes 10 of the component 9 may be exposed as above, or may not be exposed.

The inner wall of the hole 33 shown in Fig. 16(e) may be plated to form the second interlayer connection conductor 34 instead of filling the hole 33 with an electroconductive paste. The second interlayer connection conductor 34 may be formed by filling a plated hole 33 with an electroconductive paste or a non-electroconductive paste, or by injecting the electroconductive paste into the hole 33 up to a predetermined height and subsequently plating the inner wall of the hole 33.

Although the first layer 6, the second layer 31, and the third layer 32 are preferably formed of a thermosetting epoxy resin, other thermosetting or photo-curable resins may be used. A material difficult to shrink is desirably used. Preferably, the first layer 6, the second layer 31, and the third layer 32 are formed of the same 3 material, so that the thermal expansion coefficient and other properties can be uniformized in the component-embedded substrate and, thus, the reliability can be increased.

### (Fifth Embodiment)

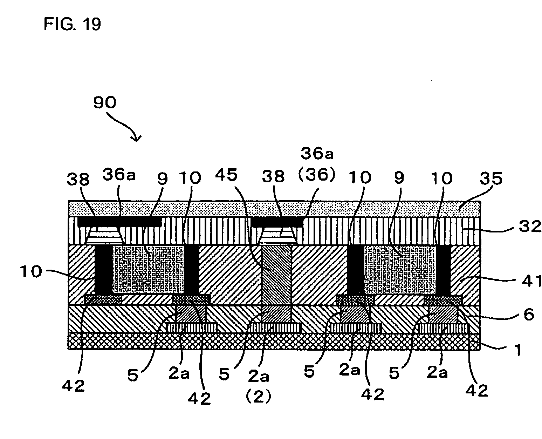

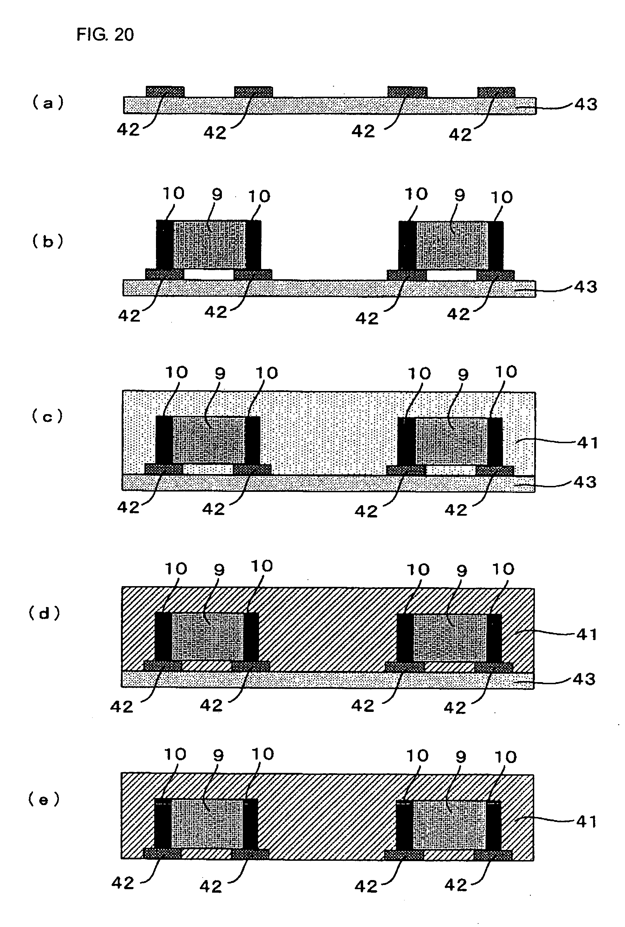

A fifth embodiment according to Claim 6 will be described with reference to Figs. 19 to 23. Fig. 19 is a sectional view of a component-embedded substrate 90, and Figs. 20 to 23 are representations of a method for manufacturing the component-embedded substrate 90. In Figs. 19 to 23, the same reference numerals as in Figs. 1 to 18 designate the same or equivalent parts.

The component-embedded substrate 90 of the present embodiment is substantially the same as in the fourth embodiment, but is different in that the component 9 is mounted on electrodes 42 and embedded in a resin layer in a second layer 41, as shown in Fig. 19. The first layer 6, the third layer 32, and the second in-plane conductor 36 are formed in the same manner as in the fourth embodiment.

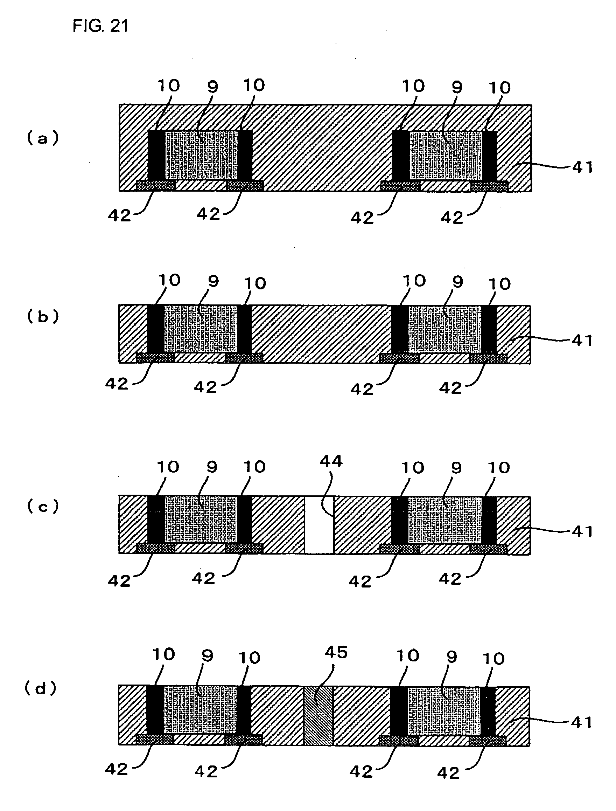

Figs. 20 and 21 are representations of the step of forming the second layer 41. First, a transfer plate 43 including electrodes 42 as shown is Fig. 20(a) is prepared, and the component 9 is mounted with its electrodes 10 aligned with the positions corresponding to the electrodes 42, as shown in Fig. 20(b). Then, the electrodes 42 and the component 9 are embedded in an uncured second layer 41, followed by curing, as shown in Figs. 20(c) and 20(d). Then, the transfer plate 43 is removed as shown in Fig. 20(e).

After the removal of the transfer plate 43, the upper surface of the second layer 41 is ground to expose the component 9 at the upper surface of the second layer 41, as shown in Figs. 21(a) and 21(b). Then, the second layer 41 is irradiated with laser light corresponding to the position of a specific first interlayer connection conductor 5 in the first layer 6 to form a hole 44 passing through the second layer 41 in the vertical direction, as shown in Fig. 21(C). In addition, as shown in Fig. 21(d), the hole 44 is filled with an electroconductive paste to form a second interlayer connection conductor 45.

Since the hole 44 is formed with the second layer 41 cured, the hole 44 is not deformed after the formation. Since the hole 44 is a through-hole formed without disposing an in-plane conductor on the upper or the lower surface, the second interlayer connection conductor 45 is not tapered, but is straight. In addition, the thickness of the second layer 41 is reduced to the extent that the component 9 is exposed at the upper surface of the second layer, and accordingly, the shape of the hole 44 can be straighter.

The third layer 32 is formed in the same manner as in the fourth embodiment. More specifically, a transfer plate 35 including the second in-plane conductor 36 is disposed on the uncured resin third layer 32 and pressed to join together, as shown in Fig. 19. The second in-plane conductor 36 is embedded in the third layer 32 at this point. In this state, the third layer 32 is irradiated with laser light from below corresponding to the positions of a plurality of lands 36a of the second in-plane conductor 36. Thus, the holes (not shown) are formed with the second in-plane conductor 36 used as the bottoms. The holes are filled with an electroconductive paste to form third interlayer connection conductors 38.

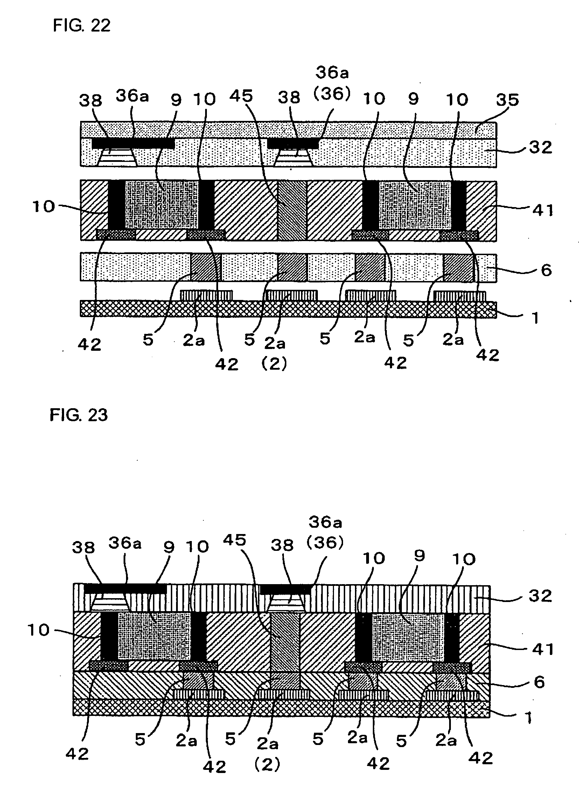

Then, the first in-plane conductor 2, the first layer 6, the second layer 41, and the third layer 32 are stacked in that order and pressed to join together, as shown in Fig. 22. In this state, the first layer 6 and the third layer 32 are cured by heating or other means to electrically connect a specific land 2a of the first in-plane conductor 2, the corresponding first interlayer connection conductor 5, the second interlayer connection conductor 45, the corresponding third interlayer connection conductor 38, and the corresponding land 36a of the second in-plane conductor 36 to one another, and other specific lands, the corresponding first interlayer connection conductors 5, the electrodes 42, and the electrodes 10 of the components, the corresponding third interlayer connection conductor 38, and the corresponding lands 36a of the second in-plane conductor 36 to one another. Thus, the component-embedded substrate 90 shown in Fig. 19 is assembled and the transfer plate 35 is removed from the upper surface of the third layer 32, as shown in Fig. 23.

The first in-plane conductor 2 in the first layer 6 may also be formed using a transfer plate, as well as the second in-plane conductor 36 in the third layer 32.

In the fifth embodiment, as described above, the component 9 is embedded in the uncured second layer 41 after being mounted on the electrode 42. Accordingly, the component 9 is difficult to displace when the second layer 41 is cured, and the first layer 6, the second layer 41, and the third layer 32 can be integrated with high positioning accuracy.

Since the thickness of the second layer 41 is reduced before being integrated with the first layer 6 and the third layer 32, the second interlayer connection conductor 45 can be formed straighter. Thus, diameter of the hole 44 intended for the second interlayer connection conductor 45 can be reduced and the pitch can be reduced. If the electrodes 10 of the component 9 are exposed at the upper surface of the second layer 41, the electrodes 10 and the third interlayer connection conductor 38 in the third layer can be electrically connected directly. Thus, wiring can be more arbitrarily performed and effective wiring becomes possible.

The step of reducing the thickness of the second layer 41 may be performed after forming the hole 44, or after filling the hole 44 with an electroconductive paste to form the second interlayer connection conductor 45, without limiting to the time before forming the hole 44, as long as this step is performed after embedding the component 9 in the second layer 41 and before integrating the first layer 6, the second layer 41, and the third layer. The thickness of the second layer 41 may not be reduced.

In the fifth embodiment, the second in-plane conductor 36 is formed using the transfer plate 35 made of, for example, SUS. This method does not require the step of patterning the second in-plane conductor 36 by etching or the like after the integration of the first layer 6, the second layer 41, and the third layer 32.

The formation of the third layer 32 is not limited to using the transfer plate 35 as in the present embodiment. For example, the second in-plane conductor may be formed by patterning a plated electroconductive layer, a copper foil, or the like, by etching or the like.

The reduction of the thickness of the second layer 41 is not limited to mechanical grinding of the upper surface of the second layer 41, and other techniques may be applied. For example, the second layer 41 may be cut to a predetermined height so that the component 9 can be exposed at the upper surface of the second layer 41. The thickness of the second layer 41 may not be reduced.

As with the first to fourth embodiments, the inner wall of the hole 44 shown in Fig. 21(c) may be plated to form the second interlayer connection conductor 45, instead of filling the hole 44 with an electroconductive paste. The interlayer connection conductor 45 may be formed by filling a plated hole 44 with an electroconductive paste or a non-electroconductive paste, or injecting the electroconductive paste into the hole 33 up to a predetermined height and subsequently plating the inner wall of the hole 44.

Although the first layer 6, the second layer 41, and the third layer 32 are preferably formed of a thermosetting epoxy resin, other thermosetting or photo-curable resins may be used. A material difficult to shrink is desirably used. Preferably, the first layer 6, the second layer 41, and the third layer 32 are formed of the same material, so that the thermal expansion coefficient and other properties can be uniformized in the component-embedded substrate and, thus, the reliability can be increased.

The present invention is not limited to the above-describe embodiments, and various modifications may be made without departing from the scope and spirit of the invention.

For example, the first embodiment may be modified to a form in which the first layer 6 is formed of an uncured resin on the upper surface of the base plate 1 having the first in-plane conductor 2 including a plurality of lands 2a on the upper surface, and the uncured first layer 6 is irradiated with laser light from above corresponding to the position of a specific land 2a of the first in-plane conductor 2 to form the first interlayer connection conductor 22 with the land 2a used as the bottom (corresponding to Claims 2 and 3), as in the third embodiment. The first interlayer connection conductor in the second, fourth, and fifth embodiments may also be formed in the same manner.

The first layer and the second layer may be formed of the same material, and the third layer may also be formed of the same material (corresponding to Claim 7).

### Industrial Applicability

The present invention can be applied to component-embedded substrates having various functions and characteristics.

## Claims

1. A method for manufacturing a component-embedded substrate, comprising;
the step of forming a first in-plane conductor including a plurality of lands;
the step of forming a first interlayer connection conductor in a first layer made of an uncured resin at a position corresponding to a specific one of the lands;
the step of embedding a component in a second layer made of an uncured resin and subsequently curing the second layer;
the step of forming a second interlayer connection conductor passing through the cured second layer from the upper surface to the lower surface at a position corresponding to the first interlayer connection conductor; and
the step of stacking the first in-plane conductor, the first layer, and the second layer in that order and subsequently curing the first layer, thereby integrating the first in-plane conductor, the first layer, and the second layer;
whereby the first in-plane conductor, the first interlayer connection conductor, and the second interlayer connection conductor are electrically connected from one to another.

2. A method for manufacturing a component-embedded substrate, comprising:
the step of forming a first interlayer connection conductor in a first layer made of an uncured resin having a first in-plane conductor including a plurality of lands, the first interlayer connection conductor having a bottom defined by a specific one of the lands;
the step of embedding a component in a second layer made of an uncured resin and subsequently curing the second layer;
the step of forming a second interlayer connection conductor passing through the second layer from the upper surface to the lower surface at a position corresponding to the first interlayer connection conductor; and
the step of stacking the first layer and the second layer in that order and subsequently curing the first layer, thereby integrating the first layer and the second layer;
whereby the first in-plane conductor, the first interlayer connection conductor, and the second interlayer connection conductor are electrically connected from one to another.

3. The method for manufacturing a component-embedded substrate according to Claim 1 or 2, further comprising the step of forming a second in-plane conductor electrically connected to the second interlayer connection conductor on the upper surface of the second layer.

4. The method for manufacturing a component-embedded substrate according to Claim 1 or 2, further comprising the step of preparing an uncured third layer having a second in-plane conductor on one surface thereof and disposing the third layer on the second layer, thereby electrically connecting the second in-plane conductor to the second interlayer connection conductor.

5. The method for manufacturing a component-embedded substrate according to any one of Claims 1 to 4, further comprising the step of exposing the component after the step of embedding the component in the uncured second layer and curing the second layer.

6. The method for manufacturing a component-embedded substrate according to any one of Claims 1 to 5, wherein the component is embedded in the uncured second layer after the component is mounted on an electrode formed on a transfer plate, and the transfer plate is removed from the second layer after the second layer is cured.

7. The method for manufacturing a component-embedded substrate according to any one of Claims 1 to 6, wherein the first layer and the second layer are formed of the same material.

8. A component-embedded substrate comprising:
a first in-plane conductor including a plurality of lands;
a first layer disposed on the first in-plane conductor;
a first interlayer connection conductor formed in the first layer and electrically connected to a specific one of the lands;
a second layer made of a resin in which a component is embedded, the second layer being disposed on the first layer;
a second interlayer connection conductor formed in the second layer and electrically connected to the first interlayer connection conductor; and
a second in-plane conductor disposed on the upper surface of the second layer and electrically connected to the second interlayer connection conductor.

9. A component-embedded substrate comprising:
a first in-plane conductor including a plurality of lands;
a resin first layer disposed on the first in-plane conductor;
an interlayer connection conductor formed in the first layer and electrically connected to a specific one of the lands;
a second layer made of a resin in which a component is embedded, the second layer being disposed on the first layer;
a second interlayer connection conductor formed in the second layer and electrically connected to the first interlayer connection conductor;
a resin third layer disposed on the second layer;
a third interlayer connection conductor formed in the third layer and electrically connected to the second interlayer connection conductor; and
a second in-plane conductor disposed in the upper surface of the third layer and electrically connected to the third interlayer connection conductor.
